(19)

**Europäisches Patentamt**
**European Patent Office**
**Office européen des brevets**

(11) **EP 3 171 513 A1**

(12) **EUROPEAN PATENT APPLICATION**

(43) Date of publication:
**24.05.2017 Bulletin 2017/21**

(51) Int Cl.:
*H03F 1/22* (2006.01)   *H03F 1/32* (2006.01)
*H03F 1/42* (2006.01)   *H03F 1/56* (2006.01)
*H03F 3/193* (2006.01)   *H03F 3/45* (2006.01)

(21) Application number: **15195513.5**

(22) Date of filing: **20.11.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Nokia Technologies Oy**
**02610 Espoo (FI)**

(72) Inventors:
• **ÖSTMAN, Kim**
 **20300 Turku (FI)**
• **REIHA, Michael**
 **Santa Clara, CA California 95050 (US)**

(74) Representative: **Nokia Corporation**
**Intellectual Property Department**
**Karakaari 7**
**02610 Espoo (FI)**

(54) **METHOD AND APPARATUS FOR AMPLIFYING SIGNALS**

(57)    There are disclosed various methods and apparatuses for amplifying a signal. In some embodiments of the method a signal is provided to at least one input (Vin) of at least one transconducting element (M1) of an amplifier. An amplified signal is formed on the basis of the input signal (Vin) by the at least one transconducting element (M1). The amplified signal is provided to at least one inductance (Lp) of an output stage. A negative conductance (Rneg) is used to adjust the output impedance of the output stage. In some embodiments the apparatus comprises means for implementing the method.

Fig. 2a

**Description**

TECHNICAL FIELD

The present invention relates to a method for amplifying signals and an apparatus for amplifying signals.

BACKGROUND

This section is intended to provide a background or context to the invention that is recited in the claims. The description herein may include concepts that could be pursued, but are not necessarily ones that have been previously conceived or pursued. Therefore, unless otherwise indicated herein, what is described in this section is not prior art to the description and claims in this application and is not admitted to be prior art by inclusion in this section.

In some apparatuses a low-noise amplifier (LNA) may be used to amplify signals so that noise possibly contributed by the amplifier is as weak as possible. These kinds of amplifiers may be used, for example, in radio receivers in a so called radio frequency (RF) front end. The low noise amplifier is intended to amplify possibly quite weak signals received by an antenna before the received signals are coupled to a mixer for converting the radio frequency signals to intermediate frequency (IF) signals or to baseband (BB) signals.

SUMMARY

Various embodiments provide a method and apparatus for amplifying signals and an apparatus for amplifying signals. In accordance with an embodiment, there is provided a low-noise transconductance amplifier that may offer wideband input matching and wideband frequency tuning at the output, with boosted linearity when desired. An output stage may be frequency-tuned with a parallel capacitor bank on a single-ended port of an output transformer, such as a balun. A tunable negative conductance array may be connected at a differential port of the output transformer.

Various aspects of examples of the invention are provided in the detailed description.

According to a first aspect, there is provided a method comprising:

providing a signal to at least one input of at least one transconducting element of an amplifier;
forming an amplified signal on the basis of the input signal by the at least one transconducting element;
providing the amplified signal to at least one inductance of an output stage; and
using a negative conductance to adjust an output impedance of the output stage.

According to a second aspect, there is provided an apparatus comprising:

at least one input for inputting a signal to an amplifier;
at least one transconducting element for amplifying the inputted signal, wherein the at least one transconducting element is adapted for forming an amplified signal on the basis of the input signal; and
an output stage comprising
at least one inductance coupled with the at least one transconducting element to receive the amplified signal; and
a negative conductance to adjust an output impedance of the output stage.

According to a third aspect, there is provided an apparatus comprising:

means for providing a signal to at least one input of at least one transconducting element of an amplifier;
means for forming an amplified signal on the basis of the input signal by the at least one transconducting element;
means for providing the amplified signal to at least one inductance of an output stage;
means for using a negative conductance to adjust an output impedance of the output stage.

In accordance with an embodiment, the low-noise transconductance amplifier may use current-mode operation, and the negative conductance may manifest as improved current source output impedance. For a complete receiver, this may boost linearity and thus may mitigate the effects of the low-noise transconductance amplifier load frequency tuning. As a result, the usable bandwidth of the low-noise transconductance amplifier output may be widened. Therefore, a greater number of frequency bands with a single amplifier may be served.

BRIEF DESCRIPTION OF THE DRAWINGS

For a more complete understanding of example embodiments of the present invention, reference is now made to the following descriptions taken in connection with the accompanying drawings in which:

Figure 1 shows a simplified block diagram of a device according to an example embodiment;
Figure 2a illustrates as a simplified circuit diagram a generic schematic of the structure of a cascode implementation of a low-noise transconductance amplifier, in which an output is connected to a current-commutating passive mixer, in accordance with an embodiment;
Figure 2b illustrates as a simplified circuit diagram a generic schematic of the structure of a non-cascode implementation of the low-noise transconductance amplifier, in which the output is connected to the current-commutating passive mixer, in accordance with an embodiment;
Figure 2c illustrates as a simplified diagram an implementation of a tunable negative conductance circuit, in accordance with an embodiment;
Figure 2d illustrates as a simplified circuit diagram a differential input implementation of the low-noise transconductance amplifier;
Figure 3 illustrates as a graph representation simulation results of the effect of tuning of a load capacitance on the output impedance, sweeping from a minimum capacitance (highest frequency) to a maximum capacitance (lowest frequency), in accordance with an embodiment;
Figures 4a to 4c illustrate as graph representations simulation results of an output impedance for different negative conductance circuit control settings at certain frequencies, in accordance with another embodiment;
Figure 5 illustrates current consumption of the low-noise transconductance amplifier at different negative conductance circuit control settings, in accordance with an embodiment;
Figure 6 illustrates a receiver noise figure and gain for different negative conductance circuit control settings at a certain local oscillator frequency, in accordance with an embodiment;
Figure 7 illustrates a receiver's half-duplex third-order intercept point for different negative conductance circuit control settings at maximum, middle, and minimum frequencies, in accordance with an embodiment;
Figure 8 illustrates receiver input matching for different negative conductance circuit control settings at a certain local oscillator frequency, in accordance with an embodiment;
Figure 9 shows a block diagram of an apparatus according to an example embodiment;
Figure 10 shows an apparatus according to an example embodiment;
Figure 11 shows an example of an arrangement for wireless communication comprising a plurality of apparatuses, networks and network elements.

## DETAILED DESCRIPTON OF SOME EXAMPLE EMBODIMENTS

The following embodiments are exemplary. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments.

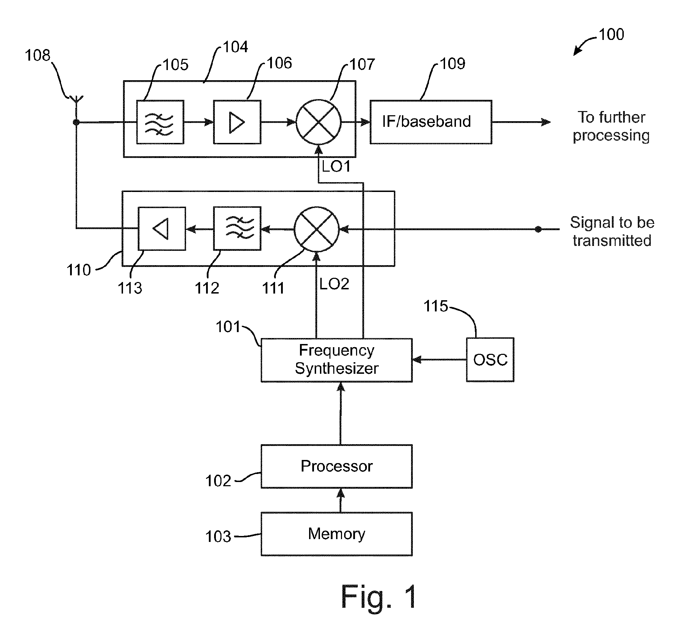

Figure 1 depicts an example of a part of a device 100, which may be, for example, a mobile device such as a mobile phone, but may also be another device comprising an amplifier 106. The device 100 may be constructed to include the frequency synthesizer 101 for generating one or more oscillator signals. The device may comprise one or more data processors 102 for controlling the operations of the device, in accordance with an embodiment. The data processor 102 operates in accordance with program instructions stored in at least one storage medium, such as at least one memory 103. The data processor 102 may control the frequency synthesizer 101 for setting the output frequency/frequencies of the frequency synthesizer 101. These output frequencies form one or more local oscillator signals that may be applied simultaneously to an RF receiver circuitry 104. The RF receiver circuitry 104 may include one or multiple instances of filters 105, amplifiers 106 and mixers 107. The RF receiver circuitry 104 may be configured to be coupled with at least one, and possibly several antennas 108, and may operate to simultaneously receive and down-convert multiple reception channels in multiple frequency bands. The RF receiver circuitry 104 may be implemented e.g. as a single direct conversion receiver, as a plurality of direct conversion receivers, as a single superheterodyne-type receiver or as a plurality of superheterodyne-type receivers. In either case the down-converted signals from multiple reception channels are provided to at least one baseband circuitry block 109 to demodulate and decode received signaling and other data.

The device of Figure 1 also comprises an RF transmitter 110 for transmitting radio frequency signals. The transmitter 110 may comprise one or more mixers 111 adapted to receive signals to be transmitted and a local oscillator signal LO2. The mixing result may be provided to a band pass filter 112 to filter out mixing results which are out of the transmission band, and a power amplifier 113 to amplify the RF signals before passing them to one or more antennas 108. The one or more antennas 108 may be the same one or more antennas that the RF receiver circuitry 104 uses or different antenna(s).

The RF receiver circuitry 104, the RF transmitter 110 and/or the baseband circuitry 109 may be embodied as an integrated circuit. In some embodiments the RF receiver circuitry 104, the RF transmitter 110 and the baseband circuitry 109 or parts of them may be embodied in the same integrated circuit, and in some other embodiments they may be embodied in different integrated circuits. In some embodiments all of the circuitry shown in Figure 1, including the data processor 102 and possibly also the memory 103, may be embodied in one integrated circuit module or package.

In some embodiments all or some of the functionality of the frequency synthesizer 101 may be embodied by the data processor 102 or by another data processor, such as a high speed digital signal processor operating under control of a stored program.

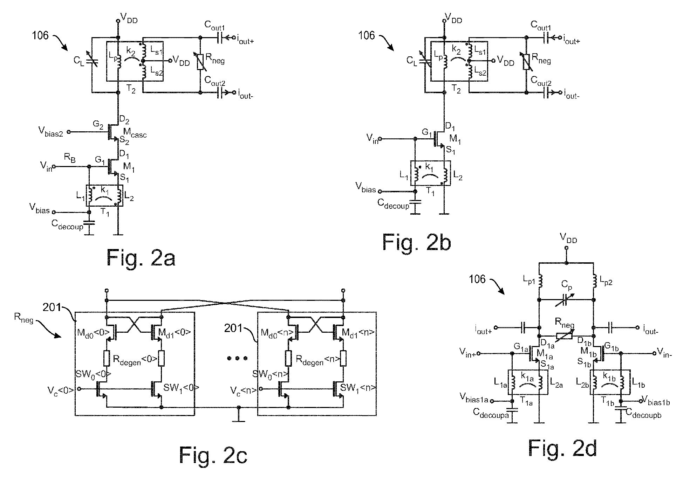

Figure 2a depicts as a simplified circuit diagram a principle of the amplifier 106, in accordance with an embodiment. The amplifier 106 may be, for example, a low noise amplifier (LNA). The amplifier 106 of Figure 2a is based on a common-source topology using a field effect transistor (FET) as a first transconductance element $M_1$. The FET is in this example an n-type metal-oxide-semiconductor FET (n-type MOSFET, NMOS). The amplifier 106 also comprises a second transconductance element $M_{casc}$, which may be, for example, an NMOSFET. The first transconductance element $M_1$ and the second transconductance element $M_{casc}$ are connected in a so called cascode configuration, wherein a drain $D_1$ of the first transconductance element $M_1$ is connected to a source $S_2$ of the second transconductance element $M_{casc}$. A source $S_1$ of the first transconductance element $M_1$ is connected to ground via a secondary inductance $L_2$ of an input transformer $T_1$. A gate G1 of the first transconductance element $M_1$ is connected to the ground via a series LC-circuit, which comprises a primary inductance $L_1$ of the input transformer $T_1$ and a decoupling capacitance $C_{decoup}$. The secondary inductance $L_2$ and a primary inductance $L_1$ have a mutual coupling k1. A first bias voltage $V_{bias}$ may be supplied to the common terminal of the primary inductance $L_1$ of the input transformer T1 and the decoupling capacitance $C_{decoup}$. Hence, the decoupling capacitance $C_{decoup}$ isolates the first bias voltage from the ground potential. A second bias voltage $V_{bias2}$ may be supplied to a gate of the second transconductance element $M_{casc}$.

In accordance with an embodiment, the cascode device may be configured so as to provide gain tuning by controlling several transconductance elements $M_{casc}$ connected in parallel (not shown).

The gate of the first transconductance element $M_1$ operates as a single-ended input $V_{in}$ of the amplifier 106 for the received radio frequency signal. The input transformer $T_1$ provides input matching and negative feedback, where the primary inductance $L_1$ may have a greater number of windings than the secondary inductance $L_2$. The ratio of the turns of the secondary inductance $L_2$ and the primary inductance $L_1$ may be indicated as 1/n. A feedback factor $\beta$ may be expressed by the effective turns ratio $k_1/n$, where $k_1$ is the magnetic coupling ratio. The effective turns ratio $k_1/n$ may simplify to 1/n, when the magnetic coupling ratio is close to 1.

A closed-loop transconductance of the first transconductance element $M_1$ may be expressed as

$$G_{cl} = \frac{i_{drain}}{v_{gen}} = \left( \frac{1}{Z_{in} + Z_{gen}} \right) \left( \frac{A}{1 + A\beta} \right) \left( \frac{A-1}{A} \right) \tag{1}$$

where A is a forward current gain from gate to source of the transconductance element $M_1$ with gate-source impedance $Z_{gs}$

$$A = \frac{i_{source}}{i_{gate}} = 1 + g_m Z_{gs} \tag{2}$$

The open-loop transconductance of the first transconductance element $M_1$ may be expressed as

$$G_{ol} = \frac{i_{drain}}{v_{gen}} = \left( \frac{1}{Z_{in} + Z_{gen}} \right) (A-1) \tag{3}$$

where $Z_{gen}$ is the impedance of the source feeding the low-noise amplifier 106 and $Z_{in}$ is the input impedance of the low-noise amplifier 106. The impedance of the source may be, for example, about 50$\Omega$. $V_{gen}$ is the input voltage from the source to the low-noise amplifier 106.

This kind of input matching technique may be used to obtain wideband operation in a current-mode low-noise amplifier, where low noise design may be challenging.

The amplifier 106 also comprises an output stage (output tank) coupled between a drain $D_2$ of the second transconductive element $M_{casc}$ and a supply VDD. In this embodiment the output stage comprises a tunable LC resonance circuitry and a tunable negative conductance array $R_{neg}$. The tunable resonance circuitry may be implemented using a variable capacitance $C_L$ and a primary inductance of an output transformer $T_2$. The tunable negative conductance array $R_{neg}$ may be connected in parallel with a secondary inductance $L_{s1}$, $L_{s2}$ of the output transformer $T_2$. A supply voltage $V_{DD}$ is provided to the amplifier 106 via the tunable LC resonance circuit. The supply voltage $V_{DD}$ may also be provided to a common terminal of the two secondary inductances $L_{s1}$, $L_{s2}$.

The output stage of the low-noise transconductance amplifier 106 may be arranged so as to provide balun functionality and subsequent differential signal processing.

In accordance with an embodiment, the turns ratio of the input transformer T1 is $n_1:1$ and the turns ratio of the output transformer T2 is $1:n_2$. In other words, the number of turns of the primary inductance $L_1$ of the input transformer T1 is $n_1$ times the number of turns of the secondary inductance $L_2$ of the input transformer T1, and the number of turns of the secondary inductance $L_{s1,s2}$ of the output transformer T2 is $n_2$ times the number of turns of the primary inductance $L_p$ of the output transformer T2.

In operation, the resonance of the output stage may be tuned to correspond with the frequency range of the signal to be received, wherein the amplifier 106 may be able to amplify signals which are located within the selected frequency range and to attenuate signals outside this frequency range.

The output stage of the above described low-noise transconductance amplifier 106 may be a narrowband LC load ($C_L$, $L_p$, $L_{s1}$, $L_{s2}$) so as to provide a tunable output impedance and a higher receiver third-order intercept point (IIP3). The output stage may perform single-ended-to-differential conversion by using the output transformer T2 such that, for example, the secondary inductances $L_{s1}$, $L_{s2}$ have greater number of windings than the primary inductance $L_p$. The impedance seen at the drain D2 of the second transconductance element $M_{casc}$ is thus reflected as a higher impedance $Z_{22}$ when viewed from the transformer secondary winding, i.e., from the output of the low-noise transconductance amplifier 106.

Frequency tuning may be performed by using a capacitor $C_L$, connected to the primary inductance $L_p$. The capacitor $C_L$ may comprise a bank of capacitors wherein capacitance tuning may be performed by connecting one or more capacitors from the bank of capacitors to the LC load. Tuning the capacitor $C_L$ may be beneficial for proper operation of the low-noise transconductance amplifier 106 e.g. in the sense of moving the frequency of maximum output impedance with the operating frequency, when the operating frequency is changed.

In some situations it may be beneficial to drive the mixers 107 by a relatively high source impedance. In other words, the output impedance of the low-noise transconductance amplifier 106 should be high, which may improve linearity of the receiver.

In accordance with an embodiment, the mixer 107, which may be a subsequent stage to the output stage of the low-noise transconductance amplifier 106, may operate in a current-mode. The mixer which operates in current-mode may have low input impedance, which may be in the order of ohms to tens of ohms. Thus, the output stage of the low-noise transconductance amplifier 106 is coupled to the low impedance load formed by the input of the mixer 107.

In the configuration of Figure 2a there is provided a tunable negative conductance array $R_{neg}$ at the secondary inductance $L_{s1}$, $L_{s2}$ of the output transformer T2. The tunable negative conductance array $R_{neg}$ is coupled in parallel to the secondary inductance $L_{s1}$, $L_{s2}$ of the output transformer T2.

Figure 2d shows as a simplified circuit diagram a principle of the amplifier 106 having a differential input, in accordance with an embodiment. The amplifier 106 of Figure 2d comprises a pair of transconductance elements $M_{1a}$, $M_{1b}$. The transconductance elements $M_{1a}$, $M_{1b}$ of the pair of transconductance elements may be similar to each other. A gate $G_{1a}$ of one transconductance element $M_{1a}$ of the pair of transconductance elements operates as a positive input $V_{in+}$ and a gate $G_{1b}$ of the other transconductance element $M_{1b}$ of the pair of transconductance elements operates as a negative input $V_{in-}$. A source $S_1a$ of the one transconductance element $M_{1a}$ of the pair of transconductance elements is connected to ground via a secondary inductance $L_{2a}$ of a first input transformer $T_{1a}$ and a source $S_{1b}$ of the other transconductance element $M_{1b}$ of the pair of transconductance elements is connected to ground via a secondary inductance $L_{2b}$ of a second input transformer $T_{1b}$. The gate $G_1a$ of the one transconductance element $M_{1a}$ of the pair of transconductance elements is connected to the ground via a first series LC-circuit, which comprises a primary inductance $L_{1a}$ of the first input transformer $T_1a$ and a first decoupling capacitance $C_{decoupa}$. The secondary inductance $L_{2a}$ and a primary inductance $L_1a$ of the first input transformer $T_1a$ have a mutual coupling $k_{1a}$. A first bias voltage may be supplied to the common terminal of the primary inductance $L_1$ of the first input transformer $T_1a$ and the first decoupling capacitance $C_{decoupa}$. Similarly, the gate $G_{1b}$ of the other transconductance element $M_{1b}$ of the pair of transconductance elements is connected to the ground via a second series LC-circuit, which comprises a primary inductance $L_{1b}$ of the second input transformer $T_{1b}$ and a second decoupling capacitance $C_{decoupb}$. The secondary inductance $L_{2b}$ and a primary inductance $L_{1b}$ of the second input transformer $T_{1b}$ have a mutual coupling $k_{1b}$.

A first bias voltage $V_{bias1a}$ may be supplied to the common terminal of the primary inductance $L_{1a}$ of the first input transformer $T_1a$ and the first decoupling capacitance $C_{decoupa}$ and a second voltage $V_{bias1b}$ may be supplied to the common terminal of the primary inductance $L_{1b}$ of the second input transformer $T_{1b}$ and the second decoupling capacitance $C_{decoupb}$.

The first input transformer $T_{1a}$ and the second first input transformer $T_{1b}$ may be similar to each other. Hence, also the mutual couplings $k_{1b}$, $k_{1b}$ may be similar to each other as well as the turns ratio $n_a$:1 of the first input transformer $T_{1a}$ and the turns ratio $n_b$:1 of the second input transformer $T_{1b}$. It is also possible that the first bias voltage $V_{bias1a}$ and the second bias voltage $V_{bias1b}$ are the same.

The output stage of the amplifier 106 of Figure 2d is coupled between drains $D_{1a}$, $D_{1b}$ of the pair of transconductive element $M_{1a}$, $M_{1b}$. The output stage comprises a tunable LC resonance circuitry $L_{p1}$, $L_{p2}$, Cp and a tunable negative conductance array $R_{neg}$. The tunable resonance circuitry may be implemented using a variable capacitance $C_p$ and a pair of inductances $L_{p1}$, $L_{p2}$. The tunable negative conductance array $R_{neg}$ may be connected in parallel with the variable capacitance $C_p$. A supply voltage $V_{DD}$ is provided to the amplifier 106 via the tunable LC resonance circuit.

Figure 2c shows an example implementation comprising parallel-connected negative conductance cells 201 with either unity or binary weighting. In this embodiment the tunable negative conductance array $R_{neg}$ comprises n cells of negative conductances 201. Each cell of negative conductances 201 may comprise cross-coupled transconductance elements $M_{d0}<0>$, $M_{d1}<0>$; ...; $M_{d0}<n>$, $M_{d1}<n>$. The source of each transconductance element may be coupled via degenerating resistors $R_{degen}<0>$; ...; $R_{degen}<n>$ to switches SWo$<0>$, SW$_1<0>$; ...; SWo$<n>$, SW$_1<n>$. The resistance values of the degenerating resistors $R_{degen}<0>$; ...; $R_{degen}<n>$ may be the same or degenerating resistors of different cells may have different resistance values. The switches SWo$<0>$, SW$_1<0>$; ...; SWo$<n>$, SW$_1<n>$ may be used to select which cell or cells are coupled to the output load at a time. In other words, tuning of the tunable negative conductance array $R_{neg}$ may be performed by providing the array of switches SWo$<0>$, SW$_1<0>$; ...; SWo$<n>$, SW$_1<n>$ a combination of control signals $V_c<0>$; ...; $V_c<n>$ so that the desired cross-coupled elements are powered up while the rest of the cross-coupled elements are not active.

One purpose of the tunable negative conductance array $R_{neg}$ is to restore and boost the low-noise transconductance amplifier output impedance when desired for enhanced linearity. The array may be powered by creating a tap on the secondary inductance $L_{s1}$, $L_{s2}$ of the output transformer T2 and biasing it to the power supply $V_{DD}$.

In the example embodiment of Figure 2c degeneration resistors $R_{degen}$ are included, which may improve linearity, since the cells may be connected relatively close to the receiver input. However, in accordance with an embodiment the degeneration resistors $R_{degen}$ are not included, wherein the cross-coupled transconductance elements $M_{d0}<0>$, $M_{d1}<0>$; ...; $M_{d0}<n>$, $M_{d1}<n>$ may be coupled directly to the switches SWo$<0>$, SW$_1<0>$; ...; SWo$<n>$, SW$_1<n>$.

Placing the tunable negative conductance array $R_{neg}$ at a node where the RF signal is transferred as a current, the tunable negative conductance array $R_{neg}$ may reflect as higher output impedance, whereas the gain may remain almost constant and improvement in linearity may be obtained.

Figure 2b shows an alternative embodiment, where the second transconductance element $M_{casc}$ is not used. Otherwise, the circuit of the low-noise transconductance amplifier 106 may be similar to the embodiment of Figure 2a.

The first transconductance element $M_1$ and the second transconductance element $M_{casc}$ may be, for example, field effect transistors (FET), such as metal-oxide silicon FETs (MOSFET), or other appropriate kinds of transistors, such as bipolar transistors.

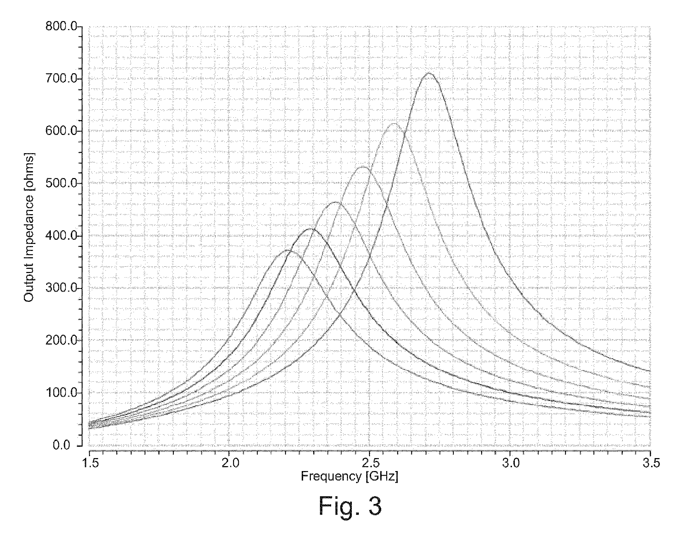

Figure 3 illustrates as a graph representation some simulation results of the effect of tuning of a load capacitance on the LNTA output impedance, sweeping from a minimum capacitance to a maximum capacitance, in accordance with an embodiment. In this example the load capacitance was simulated to be a bank of capacitances, wherein tuning may be performed by providing a four-bit control code to select the capacitance value for the load capacitance. The following control codes were used: 0, 3, 6, 9, 12 and 15. The uppermost curve in Figure 3 represents the situation in which the control code was 0, the next lower curve in Figure 3 represents the situation in which the control code was 3, etc.

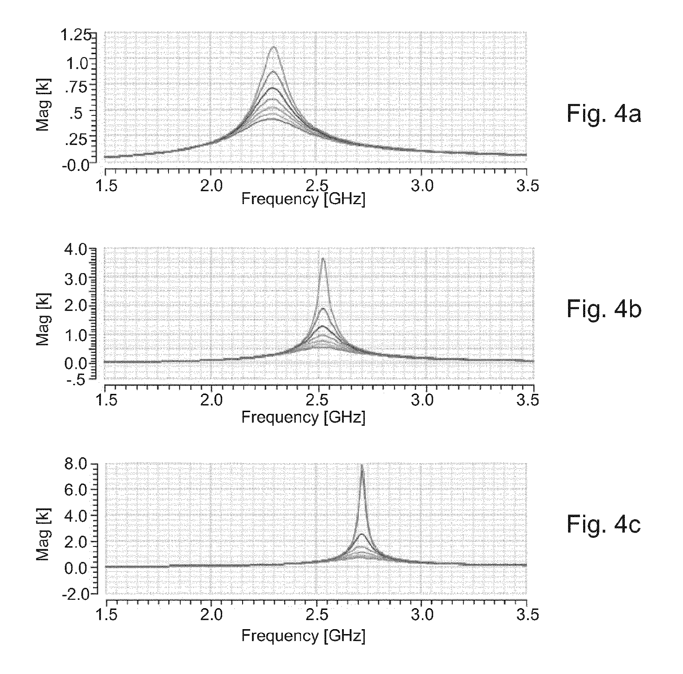

Figures 4a to 4c illustrate as graph representations simulation results of an output impedance for different negative conductance circuit control settings at $f_0$=2.3 GHz (Figure 4a), $f_0$=2.5 GHz (Figure 4b), and $f_0$=2.7 GHz (Figure 4c), in accordance with an embodiment. The center frequency was changed by tuning the load capacitance $C_L$. For each $f_0$, the output impedance was plotted for seven tuning steps of $R_{neg}$. As can be observed, the initial $Z_{22}$ is lowest (about 400 ohms) at $f_0$ = 2.3 GHz, whereas the value is about 700 ohms at $f_0$ = 2.7 GHz. By controlling the tunable negative conductance array $R_{neg}$, $Z_{22}$ at 2.3 GHz can be restored to the non-frequency-tuned 700 ohms, and even beyond. At $f_0$ = 2.7 GHz, the highest control values result in a very high $Z_{22}$, and care may be taken to prevent oscillation by limiting the range of used control values.

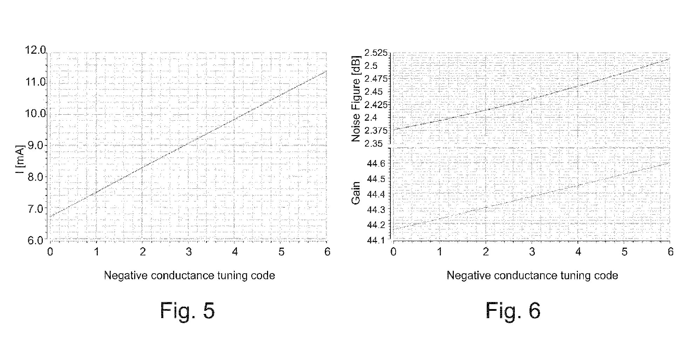

Figure 5 illustrates the current consumption of the low-noise transconductance amplifier at different negative conductance circuit control settings, in accordance with an embodiment. As shown in Figure 5, the tunable negative conductance array $R_{neg}$ may consume an additional 0.8 mA per control step in this implementation.

Figure 6 illustrates a receiver noise figure and gain for different negative conductance circuit control settings at a certain local oscillator frequency $f_0$=2.7 GHz, in accordance with an embodiment. It can be seen that the noise penalty may be less than 0.2 dB depending on control setting, whereas the gain may increase less than 0.5 dB.

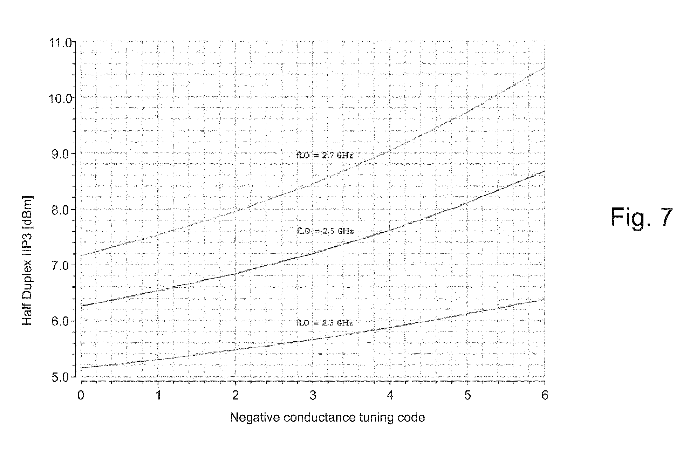

Figure 7 illustrates a receiver's half-duplex third-order intercept point for different negative conductance circuit control settings at $f_0$=2.3 GHz (lowest curve), $f_0$=2.5 GHz (middle curve), and $f_0$=2.7 GHz (top-most curve), where the closest interferer test tone is placed 60 MHz below the local oscillator frequency $f_{LO}$, in accordance with an embodiment.

The closest tone has a power of -40 dBm, and the tone close to 120 MHz below $f_{LO}$ has a power of -27 dBm. For control setting 0, the lowered $Z_{22}$ due to resonator frequency tuning manifests as a lower third-order intercept point for $f_{LO}$ = 2.5 GHz and 2.3 GHz as compared to the non-tuned $f_{LO}$ = 2.7 GHz. The third-order intercept point may then be boosted through higher control settings when required for greater receiver linearity. In contrast to voltage-mode circuits where the use of negative conductance frequency may reduce linearity, the low-noise transconductance amplifier 106 presented above may be arranged such that receiver linearity may be increased.

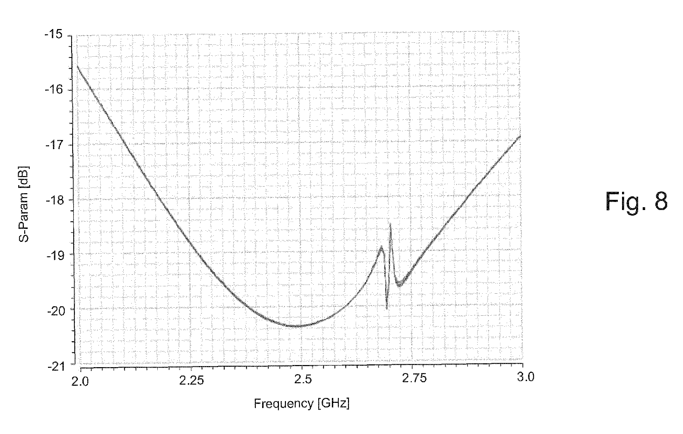

Figure 8 illustrates receiver input matching for different negative conductance circuit control settings at a certain local oscillator frequency $f_{LO}$=2.7 GHz, in accordance with an embodiment. The receiver may have wideband input matching and changes in the negative conductance circuit may have negligible effect on the matching. The changes around 2.7 GHz are due to the passive mixer connected at the output of the low-noise transconductance amplifier 106, reflected to the input due to finite isolation between the input and output of the low-noise transconductance amplifier 106.

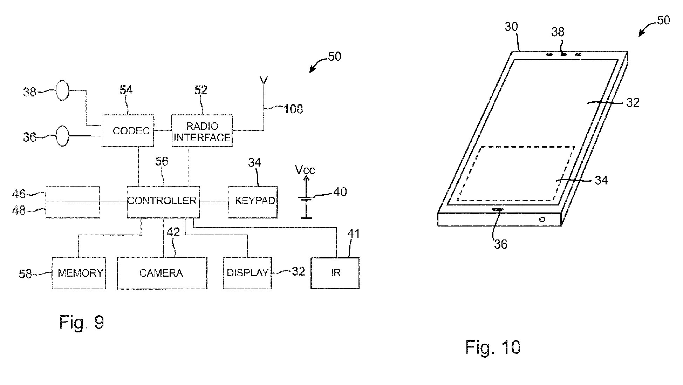

The following describes in further detail suitable apparatus and possible mechanisms for implementing the embodiments of the invention. In this regard reference is first made to Figure 9 which shows a schematic block diagram of an exemplary apparatus or electronic device 50 depicted in Figure 10, which may incorporate a transmitter according to an embodiment of the invention.

The electronic device 50 may for example be a mobile terminal or user equipment of a wireless communication system. However, it would be appreciated that embodiments of the invention may be implemented within any electronic device or apparatus which may require transmission of radio frequency signals.

The apparatus 50 may comprise a housing 30 for incorporating and protecting the device. The apparatus 50 further may comprise a display 32 in the form of a liquid crystal display. In other embodiments of the invention the display may be any suitable display technology suitable to display an image or video. The apparatus 50 may further comprise a keypad 34. In other embodiments of the invention any suitable data or user interface mechanism may be employed. For example the user interface may be implemented as a virtual keyboard or data entry system as part of a touch-sensitive display. The apparatus may comprise a microphone 36 or any suitable audio input which may be a digital or analogue signal input. The apparatus 50 may further comprise an audio output device which in embodiments of the invention may be any one of: an earpiece 38, speaker, or an analogue audio or digital audio output connection. The apparatus 50 may also comprise a battery 40 (or in other embodiments of the invention the device may be powered by any suitable mobile energy device such as solar cell, fuel cell or clockwork generator). The term battery discussed in connection with the embodiments may also be one of these mobile energy devices. Further, the apparatus 50 may comprise a combination of different kinds of energy devices, for example a rechargeable battery and a solar cell. The apparatus may further comprise an infrared port 41 for short range line of sight communication to other devices. In other embodiments the apparatus 50 may further comprise any suitable short range communication solution such as for example a Bluetooth wireless connection or a USB/firewire wired connection.

The apparatus 50 may comprise a controller 56 or processor for controlling the apparatus 50. The controller 56 may be connected to memory 58 which in embodiments of the invention may store both data and/or may also store instructions for implementation on the controller 56. The controller 56 may further be connected to codec circuitry 54 suitable for carrying out coding and decoding of audio and/or video data or assisting in coding and decoding carried out by the controller 56.

The apparatus 50 may further comprise a card reader 48 and a smart card 46, for example a universal integrated circuit card (UICC) reader and a universal integrated circuit card for providing user information and being suitable for providing authentication information for authentication and authorization of the user at a network.

The apparatus 50 may comprise radio interface circuitry 52 connected to the controller and suitable for generating wireless communication signals for example for communication with a cellular communications network, a wireless communications system or a wireless local area network. The apparatus 50 may further comprise an antenna 108 connected to the radio interface circuitry 52 for transmitting radio frequency signals generated at the radio interface circuitry 52 to other apparatus(es) and for receiving radio frequency signals from other apparatus(es).

In some embodiments of the invention, the apparatus 50 comprises a camera 42 capable of recording or detecting imaging.

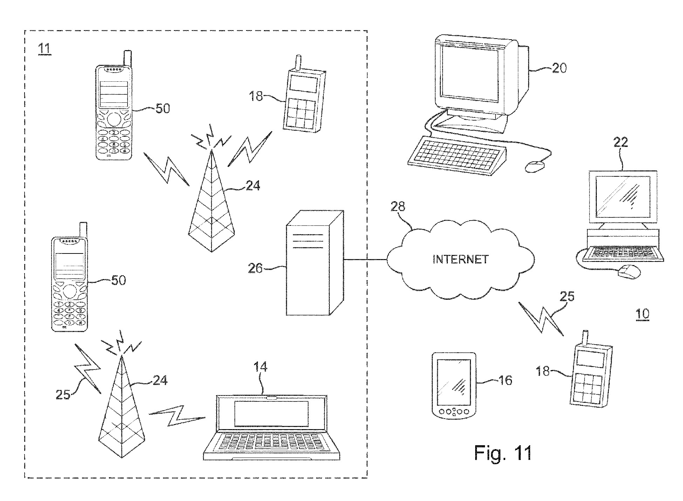

With respect to Figure 11, an example of a system within which embodiments of the present invention can be utilized is shown. The system 10 comprises multiple communication devices which can communicate through one or more networks. The system 10 may comprise any combination of wired and/or wireless networks including, but not limited to a wireless cellular telephone network (such as a global systems for mobile communications (GSM), universal mobile telecommunications system (UMTS), long term evolution (LTE) based network, code division multiple access (CDMA) network etc.), a wireless local area network (WLAN) such as defined by any of the IEEE 802.x standards, a Bluetooth personal area network, an Ethernet local area network, a token ring local area network, a wide area network, and the Internet.

For example, the system shown in Figure 11 shows a mobile telephone network 11 and a representation of the internet 28. Connectivity to the internet 28 may include, but is not limited to, long range wireless connections, short range wireless connections, and various wired connections including, but not limited to, telephone lines, cable lines, power lines, and similar communication pathways.

The example communication devices shown in the system 10 may include, but are not limited to, an electronic device or apparatus 50, a combination of a personal digital assistant (PDA) and a mobile telephone 14, a PDA 16, an integrated messaging device (IMD) 18, a desktop computer 20, a notebook computer 22, a tablet computer. The apparatus 50 may be stationary or mobile when carried by an individual who is moving. The apparatus 50 may also be located in a mode of transport including, but not limited to, a car, a truck, a taxi, a bus, a train, a boat, an airplane, a bicycle, a motorcycle or any similar suitable mode of transport.

Some or further apparatus may send and receive calls and messages and communicate with service providers through a wireless connection 25 to a base station 24. The base station 24 may be connected to a network server 26 that allows communication between the mobile telephone network 11 and the internet 28. The system may include additional communication devices and communication devices of various types.

The communication devices may communicate using various transmission technologies including, but not limited to, code division multiple access (CDMA), global systems for mobile communications (GSM), universal mobile telecommunications system (UMTS), time divisional multiple access (TDMA), frequency division multiple access (FDMA), transmission control protocol-internet protocol (TCP-IP), short messaging service (SMS), multimedia messaging service (MMS), email, instant messaging service (IMS), Bluetooth, IEEE 802.11, Long Term Evolution wireless communication technique (LTE) and any similar wireless communication technology. A communications device involved in implementing various embodiments of the present invention may communicate using various media including, but not limited to, radio, infrared, laser, cable connections, and any suitable connection. In the following some example implementations of apparatuses utilizing the present invention will be described in more detail.

Although the above examples describe embodiments of the invention operating within a wireless communication device, it would be appreciated that the invention as described above may be implemented as a part of any apparatus comprising a circuitry in which radio frequency signals are transmitted and received. Thus, for example, embodiments of the invention may be implemented in a mobile phone, in a base station, in a computer such as a desktop computer or a tablet computer comprising radio frequency communication means (e.g. wireless local area network, cellular radio, etc.).

In general, the various embodiments of the invention may be implemented in hardware or special purpose circuits or any combination thereof. While various aspects of the invention may be illustrated and described as block diagrams or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

Embodiments of the inventions may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs, such as those provided by Synopsys, Inc. of Mountain View, California and Cadence Design, of San Jose, California automatically route conductors and locate components on a semiconductor chip using well established rules of design as well as libraries of pre stored design modules. Once the design for a semiconductor circuit has been completed, the resultant design, in a standardized electronic format (e.g., Opus, GDSII, or the like) may be transmitted to a semiconductor fabrication facility or "fab" for fabrication.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention.

In the following some examples will be provided.

According to a first example, there is provided a method comprising:

providing a signal to at least one input of at least one transconducting element of an amplifier;
forming an amplified signal on the basis of the input signal by the at least one transconducting element;
providing the amplified signal to at least one inductance of an output stage; and
using a negative conductance to adjust an output impedance of the output stage.

In some embodiments the output stage comprises an output transformer having at least a primary inductance and a secondary inductance, wherein the method comprises:

providing the amplified signal to the primary inductance of the output transformer; and
using the negative conductance in at least one of the primary inductance of the output transformer and the secondary inductance of the output transformer to adjust the output impedance of the output stage.

In some embodiments the method comprises:

using a single-ended input as said input of the at least one transconducting element of the amplifier; and
using an input transformer at the input to provide feedback from the at least one transconducting element to the input.

In some embodiments the method comprises:

adjusting the negative conductance to adjust the output impedance of the output stage.

In some embodiments the method comprises:

providing the amplified signal from the output stage to a subsequent stage, which operates in a current mode.

In some embodiments the method comprises:

using a tunable capacitance at the output stage to adjust the resonance frequency of the output stage.

In some embodiments the method comprises:

supplying power to the output stage via a tap of the secondary inductance.

In some embodiments the method comprises:

using another transconducting element connected between the at least one transconducting element and the output stage to increase isolation between the input and the output stage.

In some embodiments the method comprises:

providing the input signal to a differential input of the amplifier.

According to a second example, there is provided an apparatus comprising:

at least one input for inputting a signal to an amplifier;
at least one transconducting element for amplifying the inputted signal, wherein the at least one transconducting element is adapted for forming an amplified signal on the basis of the input signal; and
an output stage comprising
at least one inductance coupled with the at least one transconducting element to receive the amplified signal; and
a negative conductance to adjust an output impedance of the output stage.

In some embodiments the apparatus further comprises:

an output transformer at the output stage having at least a primary inductance and a secondary inductance;
wherein the primary inductance of the output transformer is coupled with the at least one transconducting element; and
the negative conductance is coupled to at least one of the primary inductance of the output transformer and the secondary inductance of the output transformer.

In some embodiments the apparatus further comprises:

an input transformer at the input to provide feedback from the at least one transconducting element to the input.

In some embodiments of the apparatus the negative conductance is an adjustable negative resistance.
In some embodiments of the apparatus the output stage is coupled to a subsequent stage, which operates in a current-mode.
In some embodiments the apparatus further comprises:

a tunable capacitance at the output stage to adjust the resonance frequency of the output stage.

In some embodiments of the apparatus the secondary inductance of the output transformer comprises a tap for supplying power to the output stage.

In some embodiments of the apparatus the output stage further comprises a tunable LC resonance circuit.

In some embodiments of the apparatus the at least one transconducting element is a metal-oxide silicon field effect transistor.

In some embodiments the apparatus further comprises:

another transconducting element connected between the at least one transconducting element and the output stage to increase isolation between the input and the output stage.

In some embodiments the apparatus further comprises:

a differential input for receiving the input signal.

In some embodiments the apparatus is a part of a receiver of a wireless communication device.

According to a third example, there is provided an apparatus comprising:

means for providing a signal to at least one input of at least one transconducting element of an amplifier;
means for forming an amplified signal on the basis of the input signal by the at least one transconducting element;
means for providing the amplified signal to at least one inductance of an output stage;
means for using a negative conductance to adjust an output impedance of the output stage.

In some embodiments the output stage comprises an output transformer having at least a primary inductance and a secondary inductance, wherein the apparatus further comprises:

means for providing the amplified signal to the primary inductance of the output transformer; and
means for using the negative conductance in at least one of the primary inductance of the output transformer and the secondary inductance of the output transformer to adjust the output impedance of the output stage.

In some embodiments the apparatus comprises:

means for using a single-ended input as said input of the at least one transconducting element of the amplifier; and
means for using an input transformer at the input to provide feedback from the transconducting element to the input.

In some embodiments the apparatus comprises:

means for adjusting the negative conductance to adjust the output impedance of the output stage.

In some embodiments the apparatus comprises:

means for using a tunable capacitance at the output stage to adjust the resonance frequency of the output stage.

In some embodiments the apparatus comprises:

means for supplying power to the output stage via a tap of the secondary inductance of the output transformer.

In some embodiments the apparatus comprises:

means for using another transconducting element connected between the at least one transconducting element and the output stage to increase isolation between the input and the output stage.

In some embodiments the apparatus comprises:

means for receiving the input signal via a differential input.

**Claims**

1.  A method comprising:

    providing a signal to at least one input of at least one transconducting element of an amplifier;
    forming an amplified signal on the basis of the input signal by the at least one transconducting element;
    providing the amplified signal to at least one inductance of an output stage; and
    using a negative conductance to adjust an output impedance of the output stage.

2.  The method according to claim 1, wherein the output stage comprises an output transformer having at least a primary inductance and a secondary inductance, the method comprising:

    providing the amplified signal to the primary inductance of the output transformer; and
    using the negative conductance in at least one of the primary inductance of the output transformer and the secondary inductance of the output transformer to adjust the output impedance of the output stage.

3.  The method according to claim 1 or 2 comprising:

    using a single-ended input as said input of the at least one transconducting element of the amplifier; and
    using at least one input transformer at the input to provide feedback from the at least one transconducting element to the input.

4.  The method according to claim 1, 2 or 3 comprising:

    adjusting the negative conductance to adjust the output impedance of the output stage.

5.  The method according to any of the claims 1 to 4 comprising:

    providing the amplified signal from the output stage to a subsequent stage, which operates in a current-mode.

6.  The method according to any of the claims 1 to 5 comprising:

    using a tunable capacitance at the output stage to adjust the resonance frequency of the output stage.

7.  The method according to any of the claims 1 to 6 comprising:

    using another transconducting element connected between the at least one transconducting element and the output stage to increase isolation between the input and the output stage.

8.  An apparatus comprising:

    at least one input for inputting a signal to an amplifier;
    at least one transconducting element for amplifying the inputted signal, wherein the at least one transconducting element is adapted for forming an amplified signal on the basis of the input signal; and
    an output stage comprising
    at least one inductance coupled with the at least one transconducting element to receive the amplified signal; and
    a negative conductance to adjust an output impedance of the output stage.

9.  The apparatus according to claim 8 further comprising:

    an output transformer at the output stage having at least a primary inductance and a secondary inductance;
    wherein the primary inductance of the output transformer is coupled with the at least one transconducting element; and
    the negative conductance is coupled to at least one of the primary inductance of the output transformer and the secondary inductance of the output transformer.

10. The apparatus according to claim 8 or 9 further comprising:

at least one input transformer at the input to provide feedback from the at least one transconducting element to the input.

**11.** The apparatus according to claim 8, 9 or 10, wherein:

the negative conductance is an adjustable negative resistance.

**12.** The apparatus according to any of the claims 8 to 11, wherein:

the output stage is coupled to a subsequent stage, which operates in a current-mode.

**13.** The apparatus according to any of the claims 8 to 12, wherein:

the secondary inductance of the output transformer comprises a tap for supplying power to the output stage.

**14.** The apparatus according to any of the claims 8 to 13, wherein:

the output stage further comprises a tunable LC resonance circuit.

**15.** The apparatus according to any of the claims 8 to 14, wherein the apparatus is a part of a receiver of a wireless communication device.

Fig. 1

Fig. 2a

Fig. 2b

Fig. 2c

Fig. 2d

Fig. 3

Fig. 4a

Fig. 4b

Fig. 4c

Fig. 5

Fig. 6

Fig. 7

Fig. 8

Fig. 9

Fig. 10

Fig. 11

Europäisches
Patentamt

European
Patent Office

Office européen
des brevets

**EUROPEAN SEARCH REPORT**

Application Number

EP 15 19 5513

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ANH DINH ET AL: "A Dual-Function Filter for 5.25GHZ Narrowband and 3.6GHZ-10.1GHZ Ultrawideband Systems", INTERNATIONAL SOC CONFERENCE, 2006 IEEE, IEEE, PI, 1 September 2006 (2006-09-01), pages 39-42, XP031009978, ISBN: 978-0-7803-9781-1 * page 39, left-hand column, line 2 - page 41, right-hand column, line 13; figures 1,2,3,4 * | 1,2,4-9, 11-15 | INV. H03F1/22 H03F1/32 H03F1/42 H03F1/56 H03F3/193 H03F3/45 |
| X | ADAM C HEIBERG ET AL: "A 250 mV, 352 uW GPS Receiver RF Front-End in 130 nm CMOS", IEEE JOURNAL OF SOLID-STATE CIRCUITS, IEEE SERVICE CENTER, PISCATAWAY, NJ, USA, vol. 46, no. 4, 25 March 2011 (2011-03-25), pages 938-949, XP011479213, ISSN: 0018-9200, DOI: 10.1109/JSSC.2011.2109470 * page 939, left-hand column, line 28 - page 945, left-hand column, line 5; figures 2(a),2(b),2(c),3,11(a),12 * | 1,3-6,8, 10-12, 14,15 | |
| X | US 2015/207530 A1 (KIM SEONG JOONG [KR] ET AL) 23 July 2015 (2015-07-23) * paragraphs [0007] - [0077]; figures 1,2,8 * | 1,5-8, 12,14,15 | **TECHNICAL FIELDS SEARCHED (IPC)** H03F |

The present search report has been drawn up for all claims

| Place of search | Date of completion of the search | Examiner |
|---|---|---|
| The Hague | 17 May 2016 | Jespers, Michaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 15 19 5513

This annex lists the patent family members relating to the patent documents cited in the above-mentioned European search report.
The members are as contained in the European Patent Office EDP file on
The European Patent Office is in no way liable for these particulars which are merely given for the purpose of information.

17-05-2016

| Patent document cited in search report | Publication date | Patent family member(s) | Publication date |
|---|---|---|---|
| US 2015207530 A1 | 23-07-2015 | KR 20150086886 A<br>US 2015207530 A1 | 29-07-2015<br>23-07-2015 |

For more details about this annex : see Official Journal of the European Patent Office, No. 12/82